(19) Europäisches Patentamt
European Patent Office
Office européen des brevets

(11) **EP 1 003 176 B1**

(12) **EUROPÄISCHE PATENTSCHRIFT**

(45) Veröffentlichungstag und Bekanntmachung des Hinweises auf die Patenterteilung:
**10.08.2005 Patentblatt 2005/32**

(51) Int Cl.⁷: $G11C\ 11/15$, $G11C\ 11/16$

(21) Anmeldenummer: **99122084.9**

(22) Anmeldetag: **18.11.1999**

(54) **Magnetischer Speicher**

Magnetic memory

Mémoire magnétique

(84) Benannte Vertragsstaaten:
**DE FR GB IE IT**

(30) Priorität: **19.11.1998 DE 19853447**

(43) Veröffentlichungstag der Anmeldung:
**24.05.2000 Patentblatt 2000/21**

(73) Patentinhaber: **Infineon Technologies AG**
**81669 München (DE)**

(72) Erfinder: **Berg, Hugo van Den Dr.**
**91074 Herzogenaurach (DE)**

(74) Vertreter: **Müller - Hoffmann & Partner Patentanwälte,**
**Innere Wiener Strasse 17**
**81667 München (DE)**

(56) Entgegenhaltungen:
**EP-A- 0 613 148** WO-A-99/14760
**US-A- 6 111 781**

**Beschreibung**

Die Erfindung bezieht sich auf einen magnetischen Speicher vom wahlfreien Zugriffstyp (MRAM) mit einem Speicherzellenfeld bestehend aus einer Vielzahl von Speicherzellen, die an Kreuzungspunkten von Wort- und Senseleitungen matrixförmig angeordnet sind, und deren logische Dateninhalte durch einen magnetischen Zustand definiert sind, mit einer den Wortleitungen zugeordneten Adressierungsschaltung, vermittels welcher die Wortleitung einer oder mehrerer ausgewählter Speicherzellen, deren Dateninhalt ausgelesen werden soll, mit einer Spannung beaufschlagt wird, und mit einer den Senseleitungen zugeordneten Auswerteschaltung, vermittels welcher ein dem Dateninhalt der ausgewählten Speicherzelle bzw. Speicherzellen entsprechendes Signal erfasst bzw. ausgewertet wird.

Bei solchen matrixorganisierten magnetischen Speichern (MRAMs) ist die Dateninformation in Form einer Magnetisierungsrichtung in einer Informationsträgerschicht der an den Kreuzungspunkten von Wort- und Senseleitungen angeordneten magnetischen Speicherzellen enthalten. Um eine Speicherzelle auszulesen, wird entweder die Sense- oder die Wortleitung (im Folgenden immer die Wortleitung) mit einer Lesespannung beaufschlagt und über die Wort- oder Senseleitung das durch die den Speicherzustand wiederspiegelnde Impedanz der Speicherzelle veränderte Signal vermittels einer zugeordneten Wort- oder Senseleitungsverstärkerschaltung ausgewertet.

Der relative Unterschied in der Impedanz der Speicherzelle je nach Informationsgehalt ("Eins" oder "Null") beträgt dabei typischerweise ca. 20%, was einen vergleichsweise geringen Wert darstellt. Erschwerend zur Bestimmung des Impedanzunterschiedes kommt hinzu, dass alle anderen Speicherzellen Parallelwege zur auszulesenden Speicherzelle bilden, und so eine große parasitäre Impedanz bilden, die den Effekt des Impedanzunterschiedes der auszulesenden Speicherzelle schon bei etwa 100 Elementen pro Wortleitung um Größenordnungen schwächen, und sich auf diese Weise ungünstig auf das über die Senseleitungen abgegriffene Signal (Sensesignal), das durch eine nachfolgende Auswerteschaltung analysiert wird, auswirkt.

Herstellungsbedingt treten bei magnetischen Speichern Schwankungen der absoluten Impedanzen der Speicherzellen innerhalb einer Charge, eines Wafers und auch innerhalb des Speicherzellenfeldes eines einzelnen magnetischen Speichers auf. Das hat zur Folge, dass absolute Impedanzmessungen keinen brauchbaren Ansatz zur Bestimmung des Speicherzustandes der auszulesenden Speicherzelle darstellen.

Eine bislang bekannte Vorgehensweise, den Speicherinhalt einer Speicherzelle zu bestimmen, ist die folgende: Die Speicherzelle wird durch Aktivierung der zugehörigen Wort- und Senseleitungen und Anlegen einer Lesespannung an die Speicherzelle und Auswertung des Signals der Speicherzelle ausgelesen. Das so erhaltene Mess-Signal wird, zum Beispiel kapazitiv, zwischengespeichert. Daraufhin wird die Speicherzelle neu mit einem bekannten Wert ("Eins" oder "Null") beschrieben, wieder ausgelesen, und das neue Mess-Signal mit dem zwischengespeicherten Mess-Signal verglichen, um so den tatsächlichen Speicherzustand ermitteln zu können. Nachteilig ist hierbei offensichtlich das Vorgehen in mehreren Schritten.

Bei einem weiteren, vorbekannten Ansatz kommen Magnetreferenzschichten, die sich innerhalb der Speicherzelle befinden, zum Einsatz. Hier kann nochmals zwischen permanenten und variablen Magnetreferenzschichten unterschieden werden. Da bei permanenten Magnetreferenzschichten dieselbe Problematik, wie schon oben beschrieben mit den Schwankungen der absoluten Impedanzen, auftritt, werden sie hier nicht näher betrachtet. In ihrer magnetischen Orientierung variable Magnetreferenzschichten können, um eine Speicherzelle auszulesen, durch einen Strom durch die Wort- oder Senseleitung in einer definierten Richtung magnetisch orientiert werden (Referenzrichtung). Die Richtungsänderung der Orientierung, und damit der absoluten Impedanz, wird in diesem Falle an Stelle des absoluten Impedanzwertes ausgewertet. Die Magnetisierungsrichtung der Informationsträgerschicht, die dem Dateninhalt gleichgesetzt werden kann, bleibt hierbei erhalten und die relativ weich magnetisierte Referenzschicht wird ummagnetisiert. Es ist auch ein Speicher anwendbar, bei dem die Referenzschicht die magnetisch härtere Schicht ist und die Informationsträgerschicht umgeschaltet wird.

Alle bisher bekannten Methoden und Speicher haben den Nachteil, dass das Auslesen der Information der Speicherzelle durch nacheinander ablaufende Vorgänge geschieht, was einen größeren Zeitaufwand bedeutet.

Der Erfindung liegt die Aufgabe zu Grunde, einen magnetischen Speicher zur Verfügung zu stellen, bei dem ein Zeitverlust durch nacheinander ablaufende Vorgänge oder verfahrensbedingtes Wiedereinschreiben der Information nicht auftritt, und der eine von herstellungsbedingten Schwankungen der absoluten Impedanzen der Speicherzellen unabhängige Datenverarbeitung ermöglicht.

Diese Aufgabe wird durch einen magnetischen Speicher nach Ansprüchen 1 und 17 gelöst.

Erfindungsgemäß ist vorgesehen, dass die Auswerteschaltung eine Vergleichsschaltung besitzt, vermittels welcher ein von einem Referenzelement geliefertes Referenzsignal mit dem Sensesignal der ausgewählten Speicherzelle bzw. Speicherzellen verglichen wird.

Die Erfindung schlägt vor, den Auslesevorgang von den Einflüssen der Schwankung der absoluten Impedanzen des Wafers oder der Charge dadurch zu befreien, dass ein auf dem Speicherchip ausgebildetes Referenzelement vorgesehen wird. Dadurch wird es möglich, die Information der Speicherzelle auszulesen, ohne dass sich die starken Schwankungen der absoluten Impedanzen auswirken. Dies wird erreicht, indem mit dem Sensesignal der Speicherzelle und dem Referenzsignal der Referenzzelle in der Vergleichsschaltung ein Differenzsignal gebildet wird.

Zweckmäßigerweise ist hierbei die Vergleichsschaltung durch einen Differenzverstärker ausgebildet, dem ein Widerstand zugeordnet ist, dessen eines Ende mit einem Eingang und dessen anderes Ende mit dem Ausgang des Differenzverstärkers, und sind den Eingängen des Differenzverstärkers Widerstände vorgeschaltet.

In einer vorteilhaften Ausgestaltung der Erfindung können die Wort- und Senseleitungen einzeln durch Erdungsschalter mit der Masse verbunden werden. Der Vorteil der sich daraus ergibt ist, dass die Vielzahl der parasitären Elemente die durch die Gesamtheit der Speicherzellen gebildet wird, deutlich verringert wird, wenn die zur Signalerfassung nicht benötigten Wort- und Senseleitungen geerdet werden.

Vorteilhafterweise kann das Referenzelement derart ausgebildet sein, dass die elektrischen bzw. magnetischen Eigenschaften an die Eigenschaften der Speicherzelle(n) angepasst sind und bei Bedarf durch Variation derselben Eigenschaften auf die der Speicherzellen einstellbar ist, und dabei ausserhalb des Speicherzellenfeldes angeordnet ist. Vorteilhafterweise ist das Referenzelement direkt mit der Referenzverstärkerschaltung verbunden, die das Signal der Referenzzelle zum Referenzsignal aufbereitet.

Wenn die magnetischen bzw. elektrischen Eigenschaften der Speicherzellen innerhalb eines Speicherzellenfeldes zu sehr schwanken, kann es in Weiterführung der Erfindung von Vorteil sein, das Speicherzellenfeld in mehrere unterschiedliche Zellbereiche von zusammenhängenden Speicherzellen mit annähernd gleichen elektrischen bzw. magnetischen Eigenschaften aufzuteilen, und den Zellbereichen ein eigenes Referenzelement bzw. Referenzsignal zuzuordnen, sodass die Signalqualität des Differenzsignals des Sensesignals der auszulesenden Speicherzelle und des Referenzelements erhalten bleibt.

Vorteilhafterweise kann das Referenzelement, um möglichst gleiche magnetische bzw. elektrische Eigenschaften wie die auszulesende bzw. auszulesenden Speicherzelle(n) zu haben, als eine innerhalb des Speicherzellenfeldes liegende Speicherzelle ausgebildet sein. Dem folgend ist vorteilhafterweise die Senseleitung des Referenzelements mit der Referenzverstärkerschaltung verbunden. Das so frei wählbare räumlich variabel ausgebildete Referenzelement wird zweckmäßigerweise so gewählt, dass es neben dem auszulesenden Speicherelement liegt.

In einer besonders bevorzugten Ausführung der Erfindung liegt das Referenzelement nicht auf der gleichen Wort- und auch nicht auf der gleichen Senseleitung, also an benachbarten Wort- und/oder Senseleitungen der ausgewählten Speicherzelle(n). Zweckmäßigerweise kann in diesem Fall die Wortleitung des Referenzelements mit der Vergleichsschaltung verbunden werden.

Gemäß einer weiteren bevorzugten Ausführungsform der Erfindung sind mehrere, der auszulesenden Speicherzelle benachbarte Referenzelemente vorgesehen, deren Wortleitungen, die nicht mit der der auszulesenden Speicherzelle zusammenfallen, gemeinsam mit der Vergleichsschaltung verbunden sind. Dem folgend kann in einer weiteren Ausführungsform vorgesehen sein, dass die Senseleitungen der Referenzelemente mit anderen Spannungspegeln wie die Wortleitung der auszulesenden Speicherzelle beaufschlagt werden.

Zweckmäßigerweise sind die Speicherzellen des Speicherzellenfeldes wie folgt aufgebaut: auf einem Substrat werden Wortleitungen aufgebracht, auf denen Schichten eines ersten magnetischen Materials, einer magnetischen Tunnelbarriere und eines zweiten magnetischen Materials aufgebracht sind, auf denen, gekreuzt zu den Wortleitungen, die Senseleitungen aufgebracht sind. Der Leitwert des Schichtensystems ist proportional zu den Energieniveaudichten an den Fermikanten der beiden durch Schichten des ersten und zweiten magnetischen Materials ausgebildeten metallischen Elektroden. Dadurch, dass die Elektroden magnetisch sind, wird der Strom durch die Tunnelbarriere in zwei Spinkanäle zerlegt, wobei sich die Spinrichtung dieser Kanäle nach der Magnetisierung der Magnetschicht unterschiedlichen Typs richtet, die magnetisch härter als die andere ist. Dabei ist der Tunnelstrom in jeweils einem der Spinkanäle zu den Energieniveaudichten an beiden Seiten der Barriere für diese Spinrichtung proportional. Wird die Magnetisierungsrichtung der weicheren Schicht bezüglich der härteren geändert, ändern sich gleichzeitig die Energieniveaudichten der weicheren Schicht für beide Spinkanäle. Als Folge ändert sich der Gesamtstrom durch die Barriere.

In genauso zweckmäßiger Weise können die Speicherzellen auch durch Schichtfolgen von Magnetschichten eines ersten Typs, Entkopplungsschichten, Magnetschichten eines zweiten Typs und wiederum Entkopplungsschichten und einem Vielfachen dieser Anordnung, welche Schichtfolgen zwischen sich kreuzenden Sense- und Wortleitungen angeordnet ist, aufgebaut sein. Durch eine Drehung der Magnetisierungsrichtung z.B. der Magnetschicht ersten Typs gegenüber der Magnetschicht zweiten Typs, ändert sich der Widerstand des Schichtfolgenstapels. Der Widerstandsunterschied zwischen einer parallelen Magnetisierung der Magnetschichten ersten und zweiten Typs und einer antiparallelen Ausrichtung kann so die Bitzustände durch einen Widerstandsunterschied repräsentieren.

Zweckmäßige Weiterbildungen der Erfindung ergeben sich aus den Unteransprüchen.

Nachfolgend wird die Erfindung anhand mehrerer, in der Zeichnung dargestellter Ausführungsbeispiele weiter erläutert. Es zeigt:

Figur 1     ein schematisches Schnittbild durch einen magnetischen Speicher mit sich kreuzenden Sense- und Wortleitungen;

Figur 2        eine schematische Schnittdarstellung durch ein CPP-Element;

Figur 3        einen schematischen Aufbau eines magnetischen Speichers mit Prinzipschaltplan einer Auswerteschaltung;

Figur 4        ein schematisches Schaltbild der für die Signalbildung signifikanten Elemente;

Figur 5        einen schematischen Schaltplan eines magnetischen Speichers mit Auswerteschaltung mit einem Referenzelement außerhalb des Speicherzellenfeldes;

Figur 6        einen schematischen Schaltplan eines magnetischen Speichers mit Auswerteschaltung mit einem Referenzelement außerhalb des Speicherzellenfeldes mit in Feldern zusammengefassten magnetischen Speicherzellen;

Figur 7        einen schematischen Schaltplan eines magnetischen Speichers mit Auswerteschaltung mit einem Referenzelement außerhalb des Speicherzellenfeldes mit Erfassung des Referenzsignals über eine Senseleitung;

Figur 8        einen schematischen Schaltplan eines magnetischen Speichers mit Auswerteschaltung mit einem Referenzelement innerhalb des Speicherzellenfeldes mit Erfassung des Referenzsignals über eine Wortleitung;

Figur 9        einen schematischen Aufbau eines magnetischen Speichers mit Prinzipschaltplan einer Auswerteschaltung, die das Referenzsignal über eine Wortleitung erfasst;

Figur 10        ein schematisches Schaltbild der für die Signalbildung signifikanten Elemente, unter Zuhilfenahme eines Referenzelements;

Figur 11        einen schematischen Schaltplan eines magnetischen Speichers mit Auswerteschaltung mit einem Referenzelement innerhalb des Speicherzellenfeldes mit Erfassung des Referenzsignals über eine mit einem Schalter verbundene Wortleitung;

Figur 12        einen schematischen Schaltplan eines magnetischen Speichers mit Auswerteschaltung und mehreren Referenzelementen innerhalb des Speicherzellenfeldes mit Erfassung des Referenzsignals über Wortleitungen.

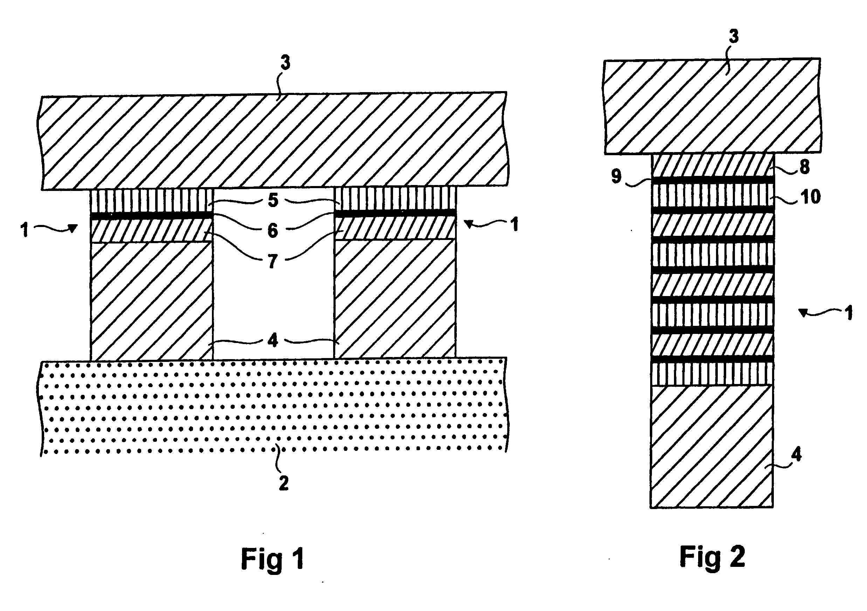

In Figur 1 ist ein Schnitt durch eine magnetischen Speicher mit Speicherzellen 1 gezeigt. Auf einem Substrat 2 sind Senseleitungen 4 aufgebracht, auf welchen darüber senkrecht zu den Senseleitungen 4 angeordneten Wortleitungen 3 vorgesehen sind. An Kreuzungspunkten zwischen den Wort- und Senseleitungen 3 und 4 ist eine Schichtenfolge von einer ersten Schicht eines magnetischen Materials 7, eine Tunnelbarrierenschicht 6 und einer zweiten Magnetschicht 5 angeordnet, die die Speicherzellen 1 bilden. Die zwei Magnetschichten 5 und 7 dienen zum einen zum Speichern der Information und zum anderen als Referenzschicht. Im Folgenden wird angenommen die Magnetschicht 7 sei die Informationsträgerschicht und die Magnetschicht 5 sei die Referenzschicht, die aus einem magnetisch weicheren Material als die Informationsträgerschicht 7 besteht. Zum Schreiben oder Lesen einer Speicherzelle 1 wird die entsprechende Wortleitungen 3 mit einer Spannung beaufschlagt und die zugehörige Senseleitung 4 wenigstens virtuell geerdet. Hierbei kann, um die Speicherzelle auszulesen, die Magnetisierungsrichtung der Referenzschicht 5 gezielt geändert werden, um den magnetischen Zustand der Informationsträgerschicht 7 zu ermitteln.

Der Leitwert des Schichtensystems ist proportional zu den Energieniveaudichten an den Fermikanten der beiden durch Schichten (5 und 7) des ersten und zweiten magnetischen Materials ausgebildeten metallischen Elektroden, welche mit zum einen mit der Wort- (3) und zum anderen mit der Senseleitung 4 verbunden sind. Dadurch, dass die Elektroden magnetisch sind, wird der Strom durch die Tunnelbarrierenschicht 6 in zwei Spinkanäle zerlegt, wobei sich die Spinrichtung dieser Kanäle nach der Magnetisierung der Magnetschicht unterschiedlichen Typs (5 oder 7) richtet, die magnetisch härter als die andere ist. Dabei ist der Tunnelstrom in jeweils einem der Spinkanäle zu den Energieniveaudichten an beiden Seiten der Barriere für diese Spinrichtung proportional. Wird die Magnetisierungsrichtung der weicheren Schicht bezüglich der härteren geändert, ändern sich gleichzeitig die Energieniveaudichten der weicheren Schicht für beide Spinkanäle. Als Folge ändert sich der Gesamtstrom durch die Barriere.

Figur 2 zeigt einen Querschnitt durch eine weitere Ausgestaltung einer magnetischen Speicherzelle 1, in Form eines Schichtfolgenstapels, der sich aus Magnetschichten eines ersten Typs 8, Entkopplungsschichten 9, Magnetschichten eines zweiten Typs 10 und wiederum Entkopplungsschichten 8, und einem Vielfachen dieser Anordnung zusammensetzt. Der Schichtfolgenstapel, der die magnetische Speicherzelle 1 bildet, ist zwischen sich kreuzenden Senseleitungen 4 und Wortleitungen 3, welche senkrecht zu den Senseleitungen 4 verlaufen, angeordnet.

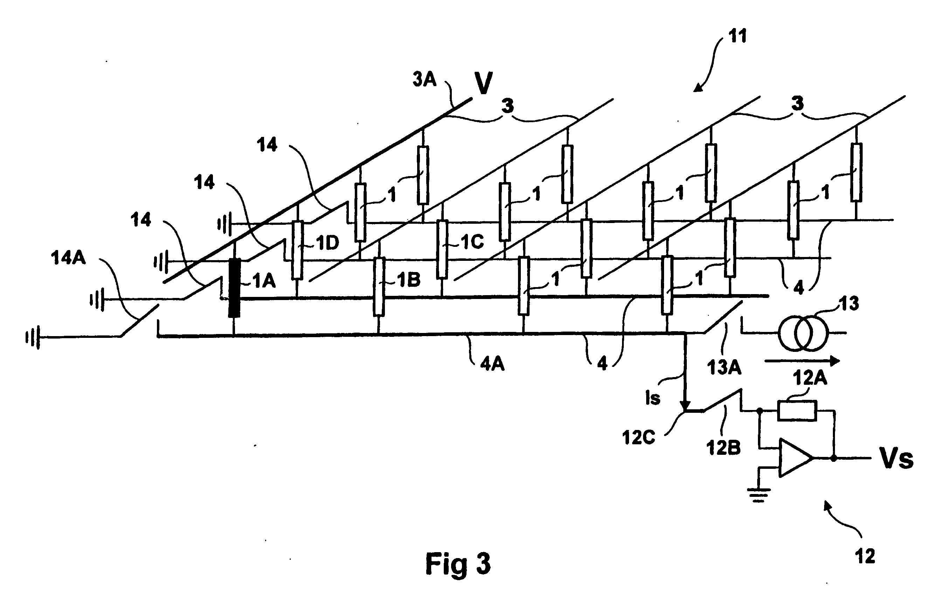

Der in Figur 3 gezeigte schematische Schaltplan eines matrixförmigen magnetischen Speichers zeigt die an den Kreuzungspunkten der Wortleitungen 3 (Anzahl M) und der Senseleitungen 4 (Anzahl N) angeordneten Speicherzellen 1. Die Senseleitungen 4 sind jeweils über Schreibstromschalter 13A mit Schreibstromquellen 13 sowie über Leseschaltern 12B mit Senseleitungsverstärkerschaltungen 12 verbunden. Die Wortleitungen 3 können um die Speicherzellen 1 auszulesen mit einer Spannung beaufschlagt werden. Soll beispielsweise die Speicherzelle 1A, die von den Speicherzellen 1B, 1C und 1D unmittelbar umgeben ist, ausgelesen werden, so wird die Wortleitung 3A mit einer Lesespannung V beaufschlagt, der Schreibstromschalter 13A geöffnet und der Leseschalter 12B geschlossen. Der sich einstellende Signalstrom Is wird über die Senseleitung 4A der auszulesenden Speicherzelle 1A vermittels der Senseleitungsverstärkerschaltung 12, deren Eingang 12C virtuell geerdet ist, ausgewertet. Der Strom-Spannungsumformer 12A dient dabei als Umformer des Signalstromes Is, der aufgrund des Impedanzunterschiedes $\Delta R/R$ der Speicherzelle 1A in deren beiden Informationszuständen ("Eins" und "Null") eine Information trägt, in das zu detektierende Signal $\Delta V$. Von Nachteil ist, dass die anderen Speicherzellen 1 Parallelwege zur auszulesenden Speicherzelle 1A bilden. Wäre der Eingang 12C nicht virtuell geerdet, sondern über eine Impedanz gekoppelt, so würden sich die Parallelwege der anderen Speicherzellen 1 insgesamt zu der parasitären Gesamtimpedanz $Z_P$, die sich zu

$$Z_P = \frac{(N+M-1)}{(M-1)(N-1)}\,R \approx \frac{1}{M-1}\,R\,; \qquad \text{für } N \gg M$$

berechnet (wobei R hier die Impedanz einer einzelnen Speicherzelle 1 darstellt) summieren. Für das zu detektierende Signal $\Delta V$ würde das bedeuteten, dass sich der Signalhub gegenüber einer einzelnen isolierten Speicherzelle nach

$$\Delta V \;=\; \frac{1}{1+\dfrac{M-1}{M}\cdot\dfrac{\Delta R}{R}}\cdot\frac{\Delta R/R}{M}\cdot\frac{R\cdot I_{LESE}}{M} \;\leq\; \frac{\Delta R/R}{M}\cdot\frac{R\cdot I_{LESE}}{M}$$

um mindestens Größenordnungen (ca. Faktor $10^4$) verringert, nimmt man eine Anzahl von nur etwa 100 Elementen pro Wortleitung an. Noch stärker mit M würde die Leistung, die benötigt wird, um die Zelle 1A für den Lesevorgang umzuprogrammieren, nach

$$E_{LESE} \;=\; \left(\frac{M\Delta V}{\Delta R/R}\right)^2 \cdot \frac{M}{R}\cdot \Delta t$$

zunehmen, so dass bei einer Pulsdauer von 10ns, etwa 100 Wortleitungen, $R=10^5\Omega$, $\Delta R/R=20\%$ $\Delta V=50mV$ pro Lesevorgang ca. 5nJ bei den Speicherzellen dissipiert würde, was für die Anwendung um Größenordnungen zu hoch wäre.

Durch virtuelle Erdung der Senseleitung 4A der auszulesenden Speicherzelle 1A und erden aller nicht benötigten Senseleitungen 4, über Erdungsschalter, kann die Zahl der signifikanten Elemente die das Netzwerk der parasitären Impedanzen und somit die parasitäre Gesamtimpedanz bilden, deutlich verringert werden. $E_{LESE}$ ist in diesem Fall nur noch proportional zu M, statt $M^3$.

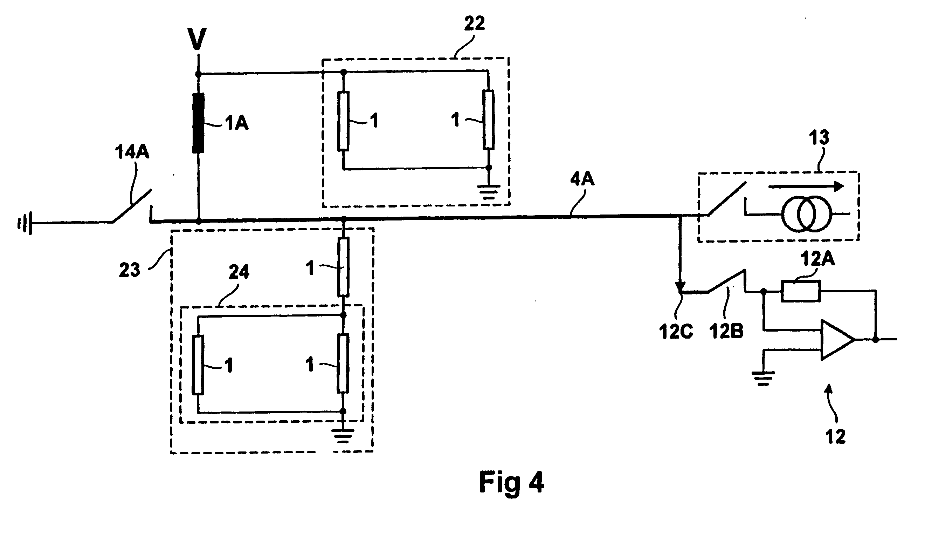

In Figur 4 ist ein schematisches Schaltbild des parasitären Netzwerks, unter Erdung der nicht benötigten Senseleitungen 4 über Erdungsschalter 14, vereinfacht dargestellt. Der Erdungsschalter 14A der Senseleitung 4A ist geöffnet. Die sich ergebenden parasitären Netzwerke 22 und 23 aus Parallel- und Serienschaltungen setzen sich dabei wie folgt zusammen: das Netzwerk 22 besteht aus einer Parallelschaltung von M-1 Speicherzellenimpedanzen der Wortleitung 3A (zwei Elemente dargestellt), das gesamte Netzwerk 23 tritt (N-1)-fach auf, wobei das Unternetzwerk 24 jeweils aus einer Parallelschaltung von M-1 Speicherzellenimpedanzen besteht (zwei Elemente dargestellt). Der Eingang 12C zur Senseleitungsverstärkerschaltung 12 ist virtuell geerdet. Deswegen wird das Ausgangssignal $\Delta V$ im wesentlichen durch die Impedanz $R_U$ des Strom-Spannungsumformers 12A und der Impedanz $R_S$ und deren Änderung $\Delta R_S$ der Auszulesenden Speicherzelle 1A nach

$$\Delta V = \frac{R_U}{R_S} \cdot \frac{\Delta R_S}{R_S} \cdot V$$

bestimmt.

Durch die Schwankung der absoluten Impedanzen $R_s$ der Speicherzellen, die durch den Herstellungsprozess des magnetischen Speichers begründet sind, können absolute Bestimmungen der Impedanz kein brauchbares Mittel zur Bestimmung des Speicherzustandes der auszulesenden Speicherzellen 1A sein.

Eine Methode den Speicherzustand einer auszulesenden Speicherzelle 1A zu bestimmen, kann die folgende Vorgehensweise sein. Durch beaufschlagen der Wortleitung 3A mit einer Lesespannung V, Messung der Impedanz der auszulesenden Speicherzelle 1A, Zwischenspeicherung des Ergebnisses, Umprogrammierung der Speicherzelle 1A auf einen definierten Speicherzustand und Vergleich des nach einer erneuten Messung der Impedanz der Speicherzelle 1A gewonnenen Ergebnisses mit dem vorherigen Ergebnis wird der Datenzustand ermittelt. Diese Methode hat aber den Nachteil, dass die Information nach dem Auslesen wieder neu eingeschrieben werden muss und der Lesevorgang in einzelne nacheinander abzuarbeitende Schritte zerfällt. Das erneute Einschreiben der Information ist nicht erforderlich, wenn die Speicherzelle aus einem so genannten hart-weich System besteht, bei dem die verwendete Magnetreferenzschicht magnetisch weicher als die Informationsträgerschicht ist, da in diesem Fall die Magnetreferenzschicht in ihrer Magnetisierungsrichtung verändert wird.

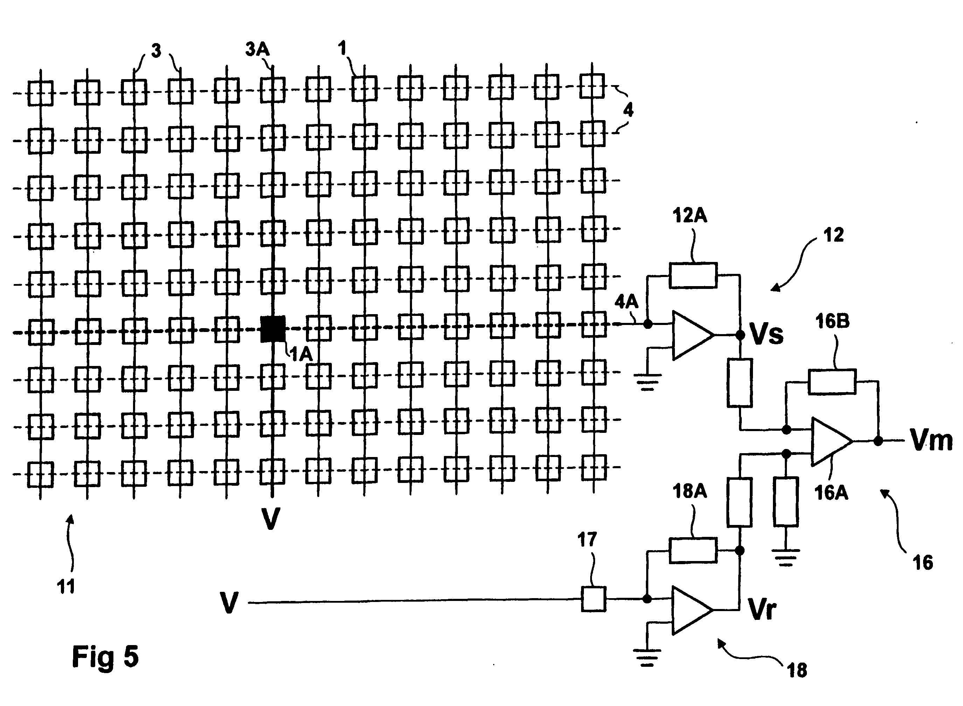

In Figur 5 ist ein schematischer Schaltplan eines magnetischen Speichers mit einem zusätzlichen Referenzelement 17 außerhalb des Speicherzellenfeldes 11 und einer zugehörigen Referenzverstärkerschaltung 18, und einer Vergleichsschaltung 16, die die Signale der Referenzverstärkerschaltung 18 und der Senseleitungsverstärkerschaltung 12 miteinander vergleicht, dargestellt. Die elektrischen bzw. magnetischen Eigenschaften des Referenzelements 17 sind an die elektrischen bzw. magnetischen Eigenschaften der Speicherzelle(n) 1 angepasst. Das kann durch verändern des Referenzelements selber (zum Beispiel der Fläche des Elements) oder durch anpassen eines zugeordneten Widerstandsnetzwerks oder der Impedanz 18A der Referenzverstärkerschaltung 18 geschehen. Für einen Auslesevorgang wird die auszulesende Speicherzelle 1A über die Wortleitung 3A mit einer Lesespannung V beaufschlagt. Der sich einstellende Signalstrom wird über die Senseleitung 4A abgegriffen und durch die Senseleitungsverstärkerschaltung 12 ausgewertet. Das so gewonnene Sensesignal Vs wird mit dem Referenzsignal Vr der Referenzverstärkerschaltung 18 vermittels der Vergleichsschaltung 16 ausgewertet, welche ein Differenzsignal aus Vs und Vr, im Folgenden Mess-Signal Vm genannt, liefert. Der Grundgedanke dieser Schaltung ist, dass die Eigenschaften der Speicherzellen 1 durch Differenzbildung deren Sensesignals Vs mit einem Signal das den elektrischen bzw. magnetischen Eigenschaften der Speicherzelle entspricht bei der Auswertung vermittels einer Vergleichsschaltung 16 eliminiert werden, so dass nur der Magnetisierungszustand der Speicherzelle das Ergebnis der Impedanzmessung bestimmt. Dadurch werden im Idealfall die störenden Einflüsse der herstellungsbedingten Schwankungen der absoluten Impedanzen der Speicherzellen von Charge zu Charge oder sogar von ganzen Speichern untereinander eines Wafers beseitigt.

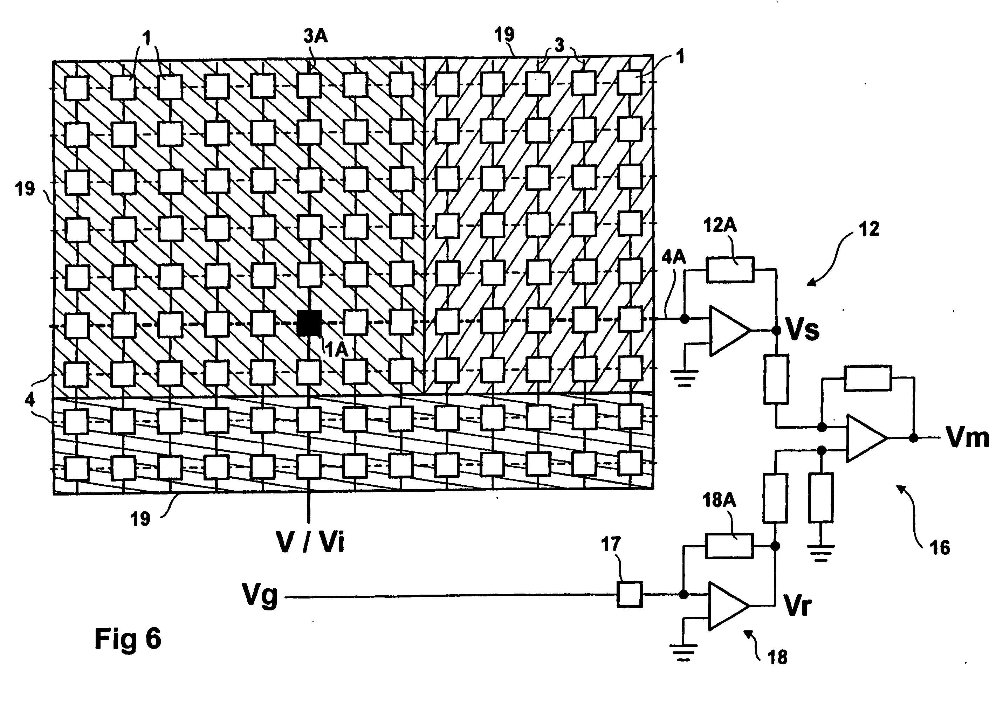

In Figur 6 ist eine weitere Ausführungsform der Erfindung zu sehen. Es werden die Speicherzellen ähnlicher Impedanzeigenschaften zu Zellbereichen 19 zusammengefasst. Diesen Zellbereichen 19 werden eigene Lesespannungen Vi zugeordnet oder die Impedanzen 12A der Senseleitungsverstärkerschaltungen 12 und/oder die der Referenzverstärkerschaltung 18 zugeordnete Impedanz 18A angepasst oder das Referenzelement 17 mit verschiedenen Spannungen Vg beaufschlagt, so dass das Mess-Signal Vm annähernd frei von störenden Einflüssen der elektrischen bzw. magnetischen Eigenschaften der Speicherzelle(n) 1 ist. Zweckmäßigerweise kann hierzu die Referenzverstärkerschaltung 18 mit zugehörigem Referenzelement 17 auch mehrfach vorhandenen sein. Für die Definition der Zellbereiche 19 und Vornahme der Einstellungen der Referenzeigenschaften muss der magnetische Speicher vermessen werden. Der zu verkraftenden Streuung der magnetischen Speichers sind hierbei Grenzen gesetzt.

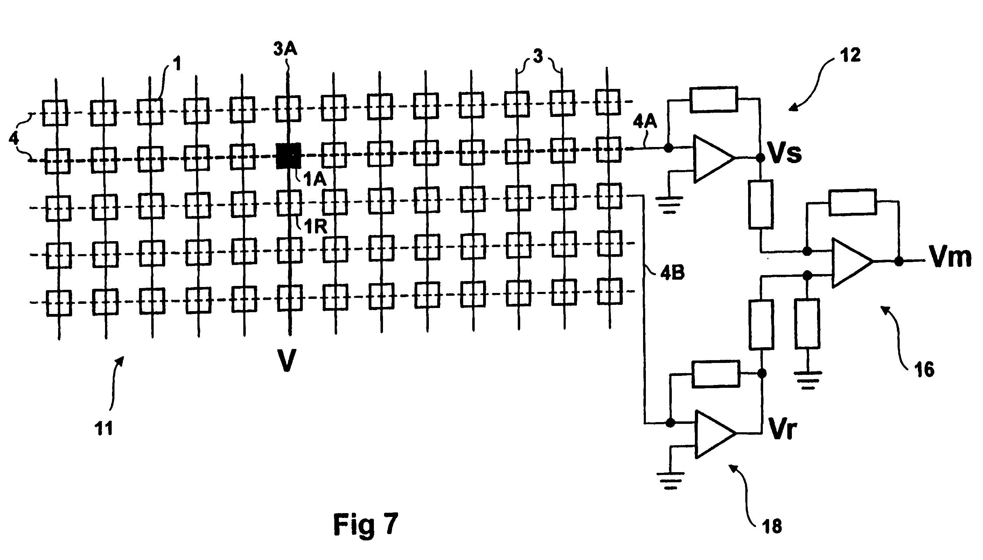

Figur 7 zeigt nun eine weitere Abwandlung der Erfindung, hier ist vorgesehen, das das Referenzelement durch eine innerhalb des Speicherzellenfeldes 11 gelegene Referenzzelle 1R ausgebildet ist. Das Signal der Referenzzelle 1R, das hierbei zweckmäßigerweise durch eine zur auszulesenden Speicherzelle 1A benachbarte Speicherzelle ausgebildet ist, wird über eine Senseleitung 4B der Referenzverstärkerschaltung 18 zugeführt. Die Referenzzelle 1R wird durch die Wortleitung 3A der auszulesenden Speicherzelle 1A mit der Lesespannung V beaufschlagt. Bei der Vergleichsmessung der Signale Vs und Vr, tritt hierbei das Problem auf, dass das Ausgangssignal Vm der Vergleichsschaltung 16 Null ist, wenn die auszulesende Speicherzelle 1A und die Referenzzelle 1R den gleichen Speicherzustand tragen, d.h. der Spannung Vm kann nicht eindeutig ein Speicherzustand der Speicherzelle 1A zugeordnet werden.

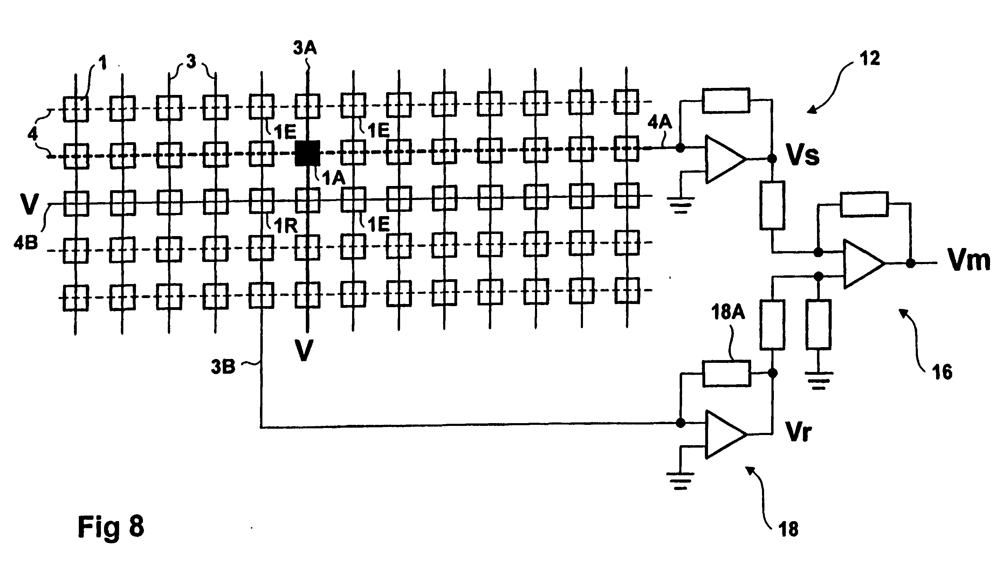

In Figur 8 wird in einer bevorzugten Ausführung der Erfindung das Signal der Referenzzelle 1R, die nun nicht mehr auf der gleichen Wortleitung 3A der auszulesenden Speicherzelle 1A liegt über die Wortleitung 3B der Referenzverstärkerschaltung 18 zugeführt. Die Speicherzellen 1E stellen hier äquivalente Zellen zur Referenzzelle 1R dar. Zur Bestimmung des Speicherzustandes wird die Senseleitung 4B, auf der sich die Referenzzelle 1R befindet und die Wortleitung 3A der auszulesenden Speicherzelle 1A mit der Lesespannung V beaufschlagt.

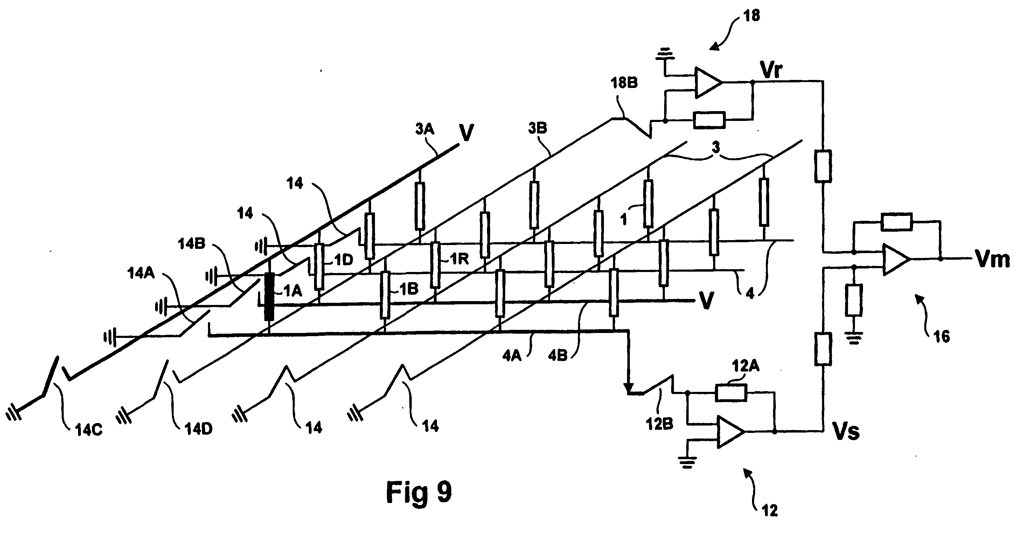

In Figur 9 ist ein schematischer Schaltplan eines magnetischen Speichers mit integriert ausgebildetem Referenzelement 1R dargestellt. Die Speicherzellen 1D, 1B und 1R sind dabei unmittelbare Nachbarn der auszulesenden Speicherzelle 1A. Alle nicht an der Messerfassung beteiligten Sense- und Wortleitungen 4 und 3 werden über geschlossene Erdungsschalter 14 geerdet (14A bis 14D geöffnet). Die Wortleitung 3A und die Senseleitung 4B werden mit der Lesespannung V beaufschlagt. Das Signal der auszulesenden Speicherzelle 1A wird über die Senseleitung 4A zur über den Leseschalter 12B zugeschalteten Senseleitungsverstärkerschaltung 12 geleitet, die am Ausgang das Sensesignal Vs bereitstellt. Das Signal der Referenzzelle 1R wird über die Wortleitung 3B und den Referenzschalter 18B zur Referenzverstärkerschaltung 18 geleitet und zum Referenzsignal Vr verarbeitet. Die Vergleichsschaltung 16 verarbeitet die beiden Signale Vr und Vs zum Mess-Signal Vm weiter.

Die Speicherzelle 1B auf der Senseleitung 4A der auszulesenden Speicherzelle 1A ist nach beiden Seiten hin durch die Eingänge der Referenzverstärkerschaltung 18 und der Senseleitungsverstärkerschaltung 12 virtuell geerdet und trägt deswegen nicht in nachteiliger Weise zum Signal des Referenzelements 1R bei. Die Speicherzelle 1D ist nach beiden Seiten hin mit der Lesespannung V auf der Wortleitung 3A und der Senseleitung 4B verbunden und bringt so keinen nachteiligen Beitrag zum Mess-Signal Vm.

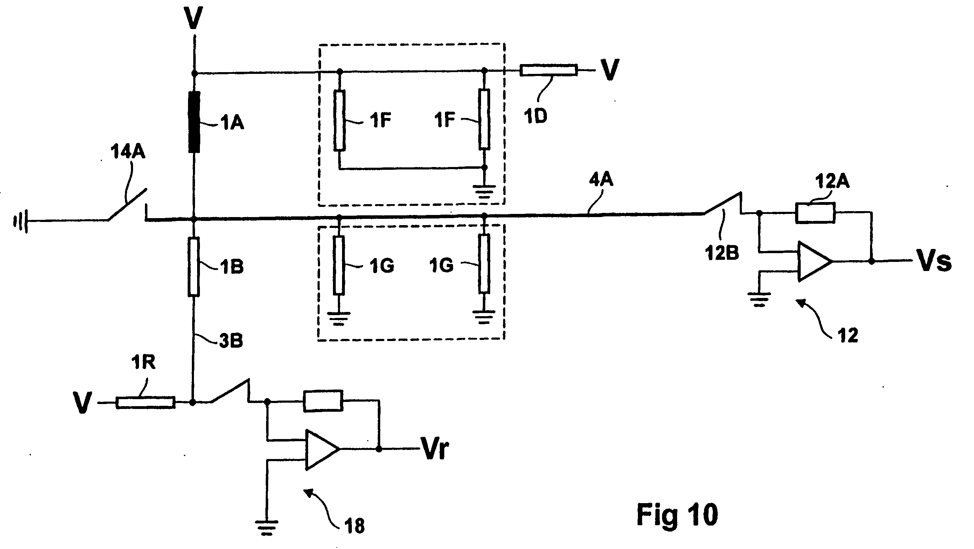

In Figur 10 ist ein schematisches Schaltbild der signifikanten parasitären Elemente, unter Erdung der nicht benötigten Senseleitungen 4 und Wortleitungen 3 über Erdungsschalter 14, vereinfacht dargestellt. Die parasitären Impedanzen 1F treten (N-2)-fach (nur zwei in der Figur dargestellt) und die parasitären Impedanzen 1G (M-2)-fach (nur zwei in der Figur dargestellt) als Parallelschaltung auf. Wie schon erwähnt trägt die nach beiden Seiten mit der Lesespannung V verbundenen Speicherzelle 1D nicht zum Signal bei. Ebenso nicht die nach beiden Seiten hin über die Eingänge der Referenzverstärkerschaltung 18 und der Senseleitungsverstärkerschaltung 12 virtuell geerdete Speicherzelle 1B. Aus der Schaltung ist ersichtlich, dass das Referenzsignal Vr fast nur von der Impedanz des Referenzelements 1R abhängt.

Eine statische Messung, ohne Beteiligung einer Magnetreferenzschicht 5, bei der die beiden Signale der Speicher- und der Referenzzelle verglichen werden hat den Nachteil, dass bei Gleichheit der Magnetisierungsrichtungen der Informationsträgerschichten 7, also der Speicherzustände, der Speicherzellen nicht entschieden werden kann, ob beide Zellen logisch Eins oder Null tragen.

Bei einer dynamischen Messung wird der Speicherinhalt der Speicherzelle und/oder der Referenzzelle nach einer ersten Messung des Mess-Signals Vm (initial) überschrieben, um einen definierten Zustand zu erreichen, und bei einer zweiten Messung das Mess-Signal Vm (final) erfasst. Der Speicherzustand wird dann durch die folgende Tabelle wiedergegeben.

| Speicherzelle 1A Dateninhalt | Referenzzelle 1R Dateninhalt | Mess-Signal Vm (initial) | Mess-Signal Vm (final) |
|---|---|---|---|
| 0 | 0 | 0 | +1 |
| 1 | 0 | +1 | +1 |
| 0 | 1 | -1 | 0 |
| 1 | 1 | 0 | 0 |

Bezieht man die Signaländerung ΔVm mit in die Signalauswertung ein, so ergeben sich nur Signale mit einem positiven Vorzeichen (Vm (final) und ΔVm in der folgenden Tabelle) und man braucht keine Signalermittlung mit Vorzeichenbestimmung vor dem Ummagnetisieren der Speicher- und/oder Referenzzelle, was zu etwas schnelleren Lesevorgängen führt.

| Speicherzelle 1A Dateninhalt | Referenzzelle 1R Dateninhalt | Mess-Signal Vm (initial) | Mess-Signal Vm (final) | Signaländerung ΔVm (ΔVs) |
|---|---|---|---|---|
| 0 | 0 | 0 | +1 | +1 |
| 1 | 0 | +1 | +1 | 0 |
| 0 | 1 | -1 | 0 | +1 |
| 1 | 1 | 0 | 0 | 0 |

Nachteilig ist die Notwendigkeit von nacheinander ermittelten Zuständen der Speicherelemente.

Nachdem z.B. nach der oben beschriebenen Art und Weise der Speicherzustand einer Speicherzelle und einer Referenzzelle, deren Signal Vr zur Bestimmung des Speicherinhalts erforderlich war, bestimmt wurden, kann, durch Speicherung des Signals Vr und unter Einbeziehung des bekannten Speicherzustandes der Referenzzelle, jeder weitere Lesevorgang mit diesen Informationen für den Vergleich geschehen. Falls die Homogenität des Speicherchips dies zulässt kann sogar eine einmalige Bestimmung des Referenzsignals Vs und des Speicherzustandes der Referenzzelle für alle weiteren Lesevorgänge ausreichen, was einem schnellen, statischen Lesen entspricht.

Eine Bestimmung auch bei Informationsgleichheit der Speicherzelle 1A und der Referenzzelle 1R kann mit Hilfe einer Magnetreferenzschicht 5 stattfinden, ohne dass das Mess-Signal Vm vor und nach einer Ummagnetisierung aufgenommen werden muss.

Bei einer solchen dynamischen Messung wird die Magnetreferenzschicht 5, welche magnetisch wesentlich weicher als die Informationsträgerschicht 7 ist, der Referenzzelle 1R durch führen eines Senseleitungsstromes Ir durch die Senseleitung 4B der Referenzzelle 1R umgeschaltet. Dabei richtet sich die Magnetisierungsrichtung der Magnetreferenzschicht 5 senkrecht zur Magnetisierungsrichtung der Informationsträgerschicht 7 der Referenzzelle 1R und senkrecht zum durch die Senseleitung 4B geführten Senseleitungsstrom Ir aus. Somit ist die Impedanz der Referenzzelle 1R unabhängig von der gespeicherten Information in der Referenzzelle 1R, spiegelt also die elektrischen bzw. magnetischen Eigenschaften der Speicherzelle(n) 1 unabhängig von der in der Referenzzelle gespeicherten Information wieder, und das Vorzeichen von Vm bestimmt eindeutig den Informationsgehalt von der auszulesenden Speicherzelle 1A. Es ist hierbei angenommen, dass die Magnetisierungsrichtungen der Informationsträgerschichten parallel zu den Senseleitungen verlaufen, es ist auch denkbar, dass sie senkrecht zu den Senseleitungen verlaufen, dann muss allerdings zur Programmierung der Speicherzelle das "Umschaltfeld" der Magnetreferenzschichten durch die Wortleitungen aufgebaut werden.

Durch diese Vorgehensweise muss die Speicherzelle nach der Bestimmung des Speicherzustands nicht wieder neu beschrieben, oder in einen definierten Zustand gebracht werden, was eine große Zeitersparnis bedeutet.

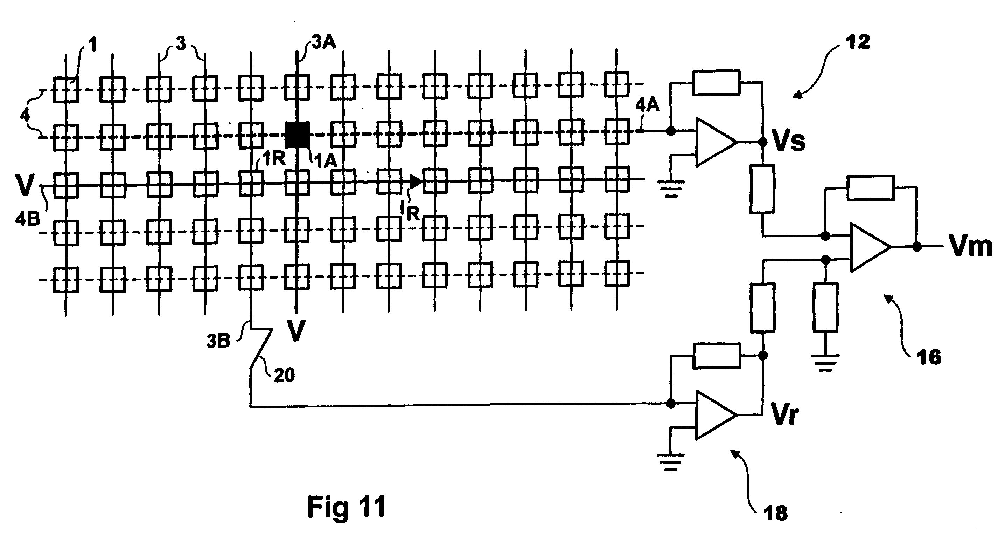

In Figur 11 ist der durch die Senseleitung 4B der Referenzzelle 1R geführte Senseleitungsstrom Ir zur Verdeutlichung eingezeichnet. In dem gezeigten Beispiel ist die Referenzverstärkerschaltung 18 einmal vorgesehen, und die jeweilige Wortleitung 3 der Referenzzelle 1R wird durch Aktivierungsschalter 20 mit der Referenzverstärkerschaltung 18 verbunden.

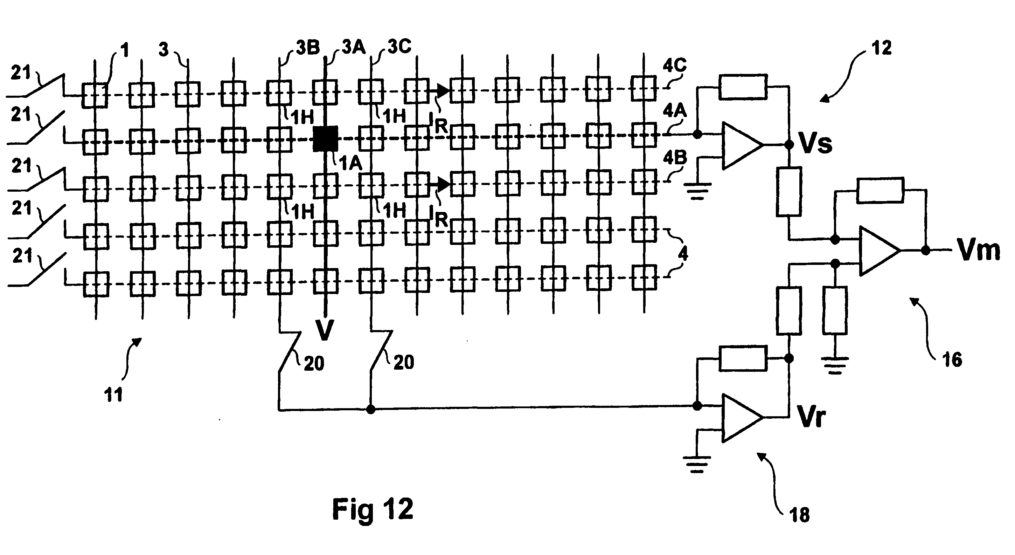

In Figur 12 ist eine weitere Ausführung der Erfindung gezeigt. In der gezeigten Anwendung werden nun zum Ausgleich starker lateraler Gradienten in der Impedanz der Speicherzellen 1 innerhalb des Speicherzellenfeldes 11 mehrere Signale von verschiedenen Referenzzellen 1H gemittelt. Es werden die symmetrisch und benachbart zur auszulesenden Speicherzelle 1A angeordneten Referenzzellen 1H über die Senseleitungen 4B und 4C durch die Senseleitungsstromschalter 21 mit einem Senseleitungsstrom Ir beaufschlagt, woraufhin die Magnetreferenzschichten 5 der Referenzzellen 1H in die neutralen Magnetisierungsrichtung gebracht werden. Die Signale der in diesem Beispiel vier Referenzzellen 1H werden von den Wortleitungen 3B und 3C über Aktivierungsschalter 20 der Referenzverstärkerschaltung 18 zugeführt. Die Referenzverstärkerschaltung 18 ist dabei so angepasst, dass das Referenzsignal Vr auf dem richtigen Niveau liegt.

## Patentansprüche

1. Magnetischer Speicher vom wahlfreien Zugriffstyp (MRAM) mit einem Speicherzellenfeld (11), bestehend aus einer Vielzahl von Speicherzellen (1), die an Kreuzungspunkten von Wort- (3) und Senseleitungen (4) matrixförmig angeordnet sind, und deren logische Dateninhalte durch einen magnetischen Zustand definiert sind, mit einer den Wortleitungen (3) zugeordneten Adressierungsschaltung, vermittels welcher die Wortleitung (3) einer oder mehrerer ausgewählter Speicherzellen (1), deren Dateninhalt ausgelesen werden soll, mit einer Lesespannung (V) beaufschlagt wird, und mit einer den Senseleitungen (4) zugeordneten Auswerteschaltung, vermittels welcher ein dem Dateninhalt der ausgewählten Speicherzelle bzw. Speicherzellen entsprechendes Signal erfasst bzw. ausgewertet wird, wobei die Auswerteschaltung eine Vergleichsschaltung (16) besitzt, vermittels welcher ein von einem Referenzelement geliefertes Referenzsignal (Vr) mit dem Sensesignal (Vs) der auszulesenden Speicherzelle bzw. Speicherzellen verglichen wird,
**dadurch gekennzeichnet,**
**dass** das Referenzelement (17) außerhalb des Speicherzellenfeldes (11) angeordnet ist und die elektrischen bzw. magnetischen Eigenschaften des Referenzelements variabel einstellbar sind.

2. Magnetischer Speicher nach Anspruch 1,
**dadurch gekennzeichnet,**
**dass** Schalter (14) vorgesehen sind, durch die die Wort- (3) und Senseleitungen (4) einzeln mit der Masse verbunden werden können.

3. Magnetischer Speicher nach Anspruch 1 oder 2,
**dadurch gekennzeichnet,**

**dass** die ausgwählte(n) Speicherzelle bzw. Speicherzellen und die Referenzzelle wenigstens an einer Seite virtuell geerdet ist.

**4.** Magnetischer Speicher nach einem der Ansprüche 1 bis 3,
**dadurch gekennzeichnet,**
**dass** die Vergleichsschaltung (16) ein Differenzsignal aus dem Sensesignal (Vs) und dem Referenzsignal (Vr) liefert.

**5.** Magnetischer Speicher nach einem der Ansprüche 1 bis 4,
**dadurch gekennzeichnet,**
**dass** die elektrischen bzw. magnetischen Eigenschaften des Referenzelements an die elektrischen bzw. magnetischen Eidenschaften der Speicherzelle(n) (1) angepasst sind.

**6.** Magnetischer Speicher nach einem der Ansprüche 1 bis 5,
**dadurch gekennzeichnet,**
**dass** das Referenzelement (17) mit einer Referenzverstärkerschaltung (18) verbunden ist.

**7.** Magnetischer Speicher nach einem der Ansprüche 1 bis 6,
**dadurch gekennzeichnet,**
**dass** das Speicherzellenfeld in mehrere unterschiedliche Zellbereiche (19) von zusammenhängenden Speicherzellen mit annähernd gleichen elektrischen bzw. magnetischen Eigenschaften aufgeteilt ist, und zu jedem Zellbereich ein angepasstes Referenzsignal oder ein eigenes Referenzelement zugeordnet ist.

**8.** Magnetischer Speicher nach einem der Ansprüche 1 bis 5,
**dadurch gekennzeichnet,**
**dass** das Referenzelement durch eine Speicherzelle (1) (Referenzzelle) des Speicherzellenfeldes ausgebildet ist.

**9.** Magnetischer Speicher nach Anspruch 8,
**dadurch gekennzeichnet,**
**dass** das Signal der Referenzzelle (1R) über eine Senseleitung (4) mit einer Referenzverstärkerschaltung (18) verbunden ist.

**10.** Magnetischer Speicher nach Anspruch 8 oder 9,
**dadurch gekennzeichnet,**
**dass** das durch eine Speicherzelle des Speicherzellenfeldes ausgebildete Referenzelement (1R) an benachbarten Wort- (3) und/oder Senseleitungen (4) der auszulesenden Speicherzelle(n) (1A) liegt.

**11.** Magnetischer Speicher nach Anspruch 8 oder 10,
**dadurch gekennzeichnet,**
**dass** die Wortleitung (3) der Referenzzelle (1R) mit der Referenzverstärkerschaltung (18) verbunden ist.

**12.** Magnetischer Speicher nach Anspruch 11,
**dadurch gekennzeichnet,**
**dass** mehrere, benachbart zur auszulesenden Speicherzelle (1A) angeordnete, Referenzzellen vorgesehen sind.

**13.** Magnetischer Speicher nach Anspruch 12,
**dadurch gekennzeichnet,**
**dass** die Referenzzellen gemeinsam mit der Referenzverstärkerschaltung (18) verbunden sind.

**14.** Magnetischer Speicher nach Anspruch 12 oder 13,
**dadurch gekennzeichnet,**
**dass** die Referenzzellen mit anderen Spannungspegeln wie die auszulesende Speicherzelle beaufschlagbar sind.

**15.** Magnetischer Speicher nach einem der Ansprüche 1 bis 14,
**dadurch gekennzeichnet,**
**dass** die Vergleichsschaltung (16) durch einen Differenzverstärker (16A) ausgebildet ist, dem ein Widerstand (16B) zugeordnet ist, dessen eines Ende mit einem Eingang und dessen anderes Ende mit dem Ausgang des Differenzverstärkers (16A) verbunden ist, und das den Eingängen des Differenzverstärkers Widerstände vorgeschaltet sind.

**16.** Magnetischer Speicher nach einem der Ansprüche 1 bis 15,
**dadurch gekennzeichnet,**
**dass** der Vergleichsschaltung (16) zum einen eine Referenzverstärkerschaltung (18) zur Aufbereitung des Signals des Referenzelements (17) oder der Referenzzelle (1R) zum Referenzsignal (Vr) und zum anderen eine Senseleitungsverstärkerschaltung (12) vorgeschaltet ist, die das Signal der auszulesenden Speicherzelle (1A) zum Sensesignal (Vs) aufbereitet.

**17.** Verfahren zum Auslesen eines magnetischen Speichers nach einem der Ansprüche 1 bis 16.

**18.** Verfahren nach Anspruch 17,
**dadurch gekennzeichnet,**
**dass** das Referenzsignal (Vr) des Referenzelements gespeichert wird, und in weiteren Bestimmungen der Speicherinhalte von Speicherzellen das gespeicherte Referenzsignal zum Vergleich mit dem Sensesignal der auszulesenden Speicherzellen verglichen wird.

**19.** Verfahren nach Anspruch 17 oder 18,
**dadurch gekennzeichnet,**
**dass** die Signale mehrerer Referenzelemente, welche benachbart zu der/den auszulesenden Speicherzelle(n) angeordnet sind, ausgewertet werden.

**20.** Verfahren nach Anspruch 19,
**dadurch gekennzeichnet,**
**dass** die Signale der mehreren Referenzelemente gemeinsam durch eine Referenzverstärkerschaltung (18) ausgewertet werden.

**21.** Verfahren nach Anspruch 19 oder 20,
**dadurch gekennzeichnet,**
**dass** die Referenzzellen mit anderen Spannungspegeln wie die auszulesende Speicherzelle beaufschlagt werden.

**22.** Verfahren nach einem der Ansprüche 17 bis 21,
**dadurch gekennzeichnet,**
**dass** die Magnetisierungsrichtung der Magnetreferenzschicht(en) eines/der als Speicherzelle(n) ausgebildeten Referenzelements/e, welche aus einer Schichtenfolge einer Magnetreferenzschicht, einer Tunnelbarriere und einer Informationsträgerschicht oder einer Schichtenfolge von Magnetreferenzschichten, Entkopplungsschichten, Informationsträgerschichten und Entkopplungsschichten, und einem Vielfachen dieser Anordnung aufgebaut ist/ sind, während des Vergleichs des Referenzsignals (Vr) mit dem Sensesignal (Vs) senkrecht zu der/den Magnetisierungsrichtung/en der Informationsträgerschicht(en) gerichtet wird/werden.

**Claims**

**1.** Magnetic memory of the random access type (MRAM) comprising a memory cell array (11) consisting of a multiplicity of memory cells (1) which are arranged in the form of a matrix at the points of intersection of word lines (3) and sense lines (4) and the logical data contents of which are defined by a magnetic state, comprising an addressing circuit allocated to the word lines (3), by means of which a read voltage (V) is applied to the word line (3) of one or more selected memory cells (1), the data contents of which are to be read out, and comprising an evaluation circuit allocated to the sense lines (4), by means of which a signal corresponding to the data contents of the selected memory cell or memory cells is acquired and evaluated, respectively, the evaluation circuit having a comparator circuit (16) by means of which a reference signal (Vr) supplied by a reference element is compared with the sense signal (Vs) of the memory cell or memory cells to be read out, **characterized in that** the reference element (17) is arranged outside the memory cell array (11) and the electrical and magnetic characteristics, respectively, of the reference element are variably adjustable.

**2.** Magnetic memory according to Claim 1, **characterized in that** switches (14) are provided by means of which the word lines (3) and sense lines (4) can be individually connected to earth.

**3.** Magnetic memory according to Claim 1 or 2, **characterized in that** the selected memory cell or memory cells and the reference cell are virtually earthed at least at one end.

4. Magnetic memory according to one of Claims 1 to 3, **characterized in that** the comparator circuit (16) supplies a difference signal of the sense signal (Vs) and the reference signal (Vr).

5. Magnetic memory according to one of Claims 1 to 4, **characterized in that** the electrical and magnetic characteristics, respectively, of the reference element are matched to the electrical and magnetic characteristics, respectively, of the memory cell(s) (1).

6. Magnetic memory according to one of Claims 1 to 5, **characterized in that** the reference element (17) is connected to a reference amplifier circuit (18).

7. The magnet memory as claimed in one of Claims 1 to 6, **characterized in that** the memory cell array is divided into a number of different cell areas (19) of contiguous memory cells having approximately the same electrical and magnetic characteristics, respectively, and a matching reference signal or a separate reference element is allocated to each cell area.

8. Magnetic memory according to one of Claims 1 to 5, **characterized in that** the reference element is formed by a memory cell (1) (reference cell) of the memory cell array.

9. Magnetic memory according to Claim 8, **characterized in that** the signal of the reference cell (1R) is connected to a reference amplifier circuit (18) via a sense line (4).

10. Magnetic memory according to Claim 8 or 9, **characterized in that** the reference element (1R) formed by a memory cell of the memory cell array is located on adjacent word lines (3) and/or sense lines (4) of the memory cell(s) (1A) to be read out.

11. Magnetic memory according to Claim 8 or 10, **characterized in that** the word line (3) of the reference cell (1R) is connected to the reference amplifier circuit (18).

12. Magnetic memory according to Claim 11, **characterized in that** a number of reference cells arranged adjacently to the memory cell (1A) to be read out are provided.

13. Magnetic memory according to Claim 12, **characterized in that** the reference cells are jointly connected to the reference amplifier circuit (18).

14. Magnetic memory according to Claim 12 or 13, **characterized in that** different voltage levels from the memory cell to be read out can be applied to the reference cells.

15. Magnetic memory according to one of Claims 1 to 14, **characterized in that** the comparator circuit (16) is formed by a differential amplifier (16A) which is associated with a resistor (16B), one end of which is connected to one input and the other end of which is connected to the output of the differential amplifier (16A) and that resistors are connected in series with the inputs of the differential amplifier.

16. Magnetic memory according to one of Claims 1 to 15, **characterized in that** the comparator circuit (16) is connected, on the one hand, in series with a reference amplifier circuit (18) for processing the signal of the reference element (17) or of the reference cell (1R) to become the reference signal (Vr) and, on the other hand, in series with a sense line amplifier circuit (12) which processes the signal of the memory cell (1A) to be read out to become the sense signal (Vs).

17. Method for reading out a magnetic memory according to one of Claims 1 to 16.

18. Method according to Claim 17, **characterized in that** the reference signal (Vr) of the reference element is stored and the stored reference signal is compared with the sense signal of the memory cells to be read out for the comparison in further determinations of the memory contents of memory cells.

19. Method according to Claim 17 or 18, **characterized in that** the signals of a number of reference elements, which are arranged adjacently to the memory cell(s) to be read out are evaluated.

20. Method according to Claim 19, **characterized in that** the signals of the several reference elements are evaluated jointly by means of a reference amplifier circuit (18).

21. Method according to Claim 19 or 20, **characterized in that** different voltage levels from the memory cell to be read out are applied to the reference cells.

22. Method according to one of Claims 17 to 21, **characterized in that** the direction of magnetization of the magnetic reference layer(s) of a/the reference element(s) constructed as memory cell(s), which is (are) constructed of a sequence of layers of a magnetic reference layer, of a tunnel barrier and of an information carrier layer or of a sequence of layers of magnetic reference layers, decoupling layers, information carrier layers and decoupling layers, and a multiple of this arrangement, is (are) directed perpendicularly to the direction(s) of magnetization of the information carrier layer(s) during the comparison of the reference signal (Vr) with the sense signal (Vs).

**Revendications**

1. Mémoire magnétique du type à accès ligne directe (MRAM) comprenant un champ (11) de cellules de mémoire constitué d'une pluralité de cellules (1) de mémoire qui sont disposées en forme de matrice aux points d'intersection de lignes (3) de mots et de lignes (4) de lecture et dont les contenus de données logiques sont définis par un état magnétique, comprenant un circuit d'adressage qui est associé aux lignes (3) de mots et au moyen duquel la ligne (3) de mots d'une ou de plusieurs cellules (1) de mémoire sélectionnée(s), dont il faut lire le contenu de données, est mise sous une tension (V) de lecture, et comprenant un circuit d'exploitation qui est associé aux lignes (4) de lecture et au moyen duquel est détecté et exploité un signal correspondant au contenu des données de la cellule de mémoire ou des cellules de mémoire sélectionnée(s), le circuit d'exploitation ayant un circuit (16) de comparaison au moyen duquel un signal (Vr) de référence fourni par un élément de référence est comparé au signal (Vs) de lecture de la cellule de mémoire ou des cellules de mémoire à lire,
   **caractérisée**
   **en ce que** l'élément (17) de référence est disposé à l'extérieur du champ (11) de cellules de mémoire et les propriétés électriques ou magnétiques de l'élément de référence peuvent être réglées de manière variable.

2. Mémoire magnétique suivant la revendication 1, **caractérisée en ce qu'**il est prévu des interrupteurs (14) par lesquels les lignes (3) de mots et les lignes (4) de lecture peuvent être reliées individuellement à la masse.

3. Mémoire magnétique suivant la revendication 1 ou 2, **caractérisée en ce que** la cellule de mémoire ou les cellules de mémoire sélectionnée(s) et la cellule de référence sont mises virtuellement à la terre au moins d'un côté.

4. Mémoire magnétique suivant l'une des revendications 1 à 3, **caractérisée en ce que** le circuit (16) de comparaison fournit un signal de différence entre le signal (Vs) de lecture et le signal (Vr) de référence.

5. Mémoire magnétique suivant l'une des revendications 1 à 4, **caractérisée en ce que** les propriétés électriques ou magnétiques de l'élément de référence sont adaptées aux propriétés électriques ou magnétiques de la cellule ou des cellules (1) de mémoire.

6. Mémoire magnétique suivant l'une des revendications 1 à 5, **caractérisée en ce que** l'élément (17) de référence est relié à un circuit (18) amplificateur de référence.

7. Mémoire magnétique suivant l'une des revendications 1 à 6, **caractérisée en ce que** le champ de cellules de mémoire est subdivisé en plusieurs parties (19) différentes de cellule de mémoire en grappe ayant des propriétés électriques ou magnétiques à peu près identiques et à chaque partie de cellule est associé un signal de référence adapté ou un élément de référence propre.

8. Mémoire magnétique suivant l'une des revendications 1 à 5, **caractérisée en ce que** l'élément de référence est constitué par une cellule (1) de mémoire (cellule de référence) du champ de cellules de mémoire.

9. Mémoire magnétique suivant la revendication 8, **caractérisée en ce que** le signal de la cellule (1 R) de référence est relié par une ligne (4) de lecture à un circuit (18) amplificateur de référence.

10. Mémoire magnétique suivant la revendication 8 ou 9, **caractérisée en ce que** l'élément (1 R) de référence constitué par une cellule de mémoire du champ de cellules de mémoire se trouve sur des lignes (3) de mots et/ou des lignes (4) de lecture voisines de la ou des cellules (1 A) de mémoire à lire.

**11.** Mémoire magnétique suivant la revendication 8 ou 10, **caractérisée en ce que** la ligne (3) de mots de la cellule (1 R) de référence est reliée au circuit (18) amplificateur de référence.

**12.** Mémoire magnétique suivant la revendication 11, **caractérisée en ce qu'**il est prévu plusieurs cellules de référence disposées au voisinage de la cellule (1 A) de mémoire à lire.

**13.** Mémoire magnétique suivant la revendication 12, **caractérisée en ce que** les cellules de référence sont reliées conjointement au circuit (18) amplificateur de référence.

**14.** Mémoire magnétique suivant la revendication 12 ou 13, **caractérisée en ce que** les cellules de référence peuvent être alimentées par d'autres niveaux de tension que la cellule de mémoire à lire.

**15.** Mémoire magnétique suivant l'une des revendications 1 à 14, **caractérisée en ce que** le circuit (16) de comparaison est constitué par un amplificateur (16A) différentiel auquel est associée une résistance (16B) dont une extrémité est reliée à une entrée et dont l'autre extrémité est reliée à la sortie de l'amplificateur (16A) différentiel et **en ce que** des résistances sont montées en amont des entrées de l'amplificateur différentiel.

**16.** Mémoire magnétique suivant l'une des revendications 1 à 15, **caractérisée en ce qu'**en amont du circuit (16) de comparaison sont montés d'une part un circuit (18) amplificateur de référence pour la transformation en le signal (Vr) de référence du signal de l'élément (17) de référence ou de la cellule (1 R) de référence et d'autre part un circuit (12) amplificateur de lignes de lecture qui transforme en un signal (Vs) de lecture le signal de la cellule (1A) de mémoire à lire.

**17.** Procédé de lecture d'une mémoire magnétique suivant l'une des revendications 1 à 16.

**18.** Procédé suivant la revendication 17, **caractérisé en ce que** le signal (Vr) de référence de l'élément de référence est mémorisé et, lors de déterminations supplémentaires des contenus des cellules de mémoire, le signal de référence mémorisé est comparé au signal de lecture des cellules de mémoire à lire.

**19.** Procédé suivant la revendication 17 ou 18, **caractérisé en ce que** l'on exploite les signaux de plusieurs éléments de référence qui sont disposés au voisinage de la ou des cellules de mémoire à lire.

**20.** Procédé suivant la revendication 19, **caractérisé en ce que** l'on exploite les signaux des plusieurs éléments de référence conjointement par un circuit (18) amplificateur de référence.

**21.** Procédé suivant la revendication 19 ou 20, **caractérisé en ce que** l'on met les cellules de référence sous des niveaux de tension autres que la cellule de lecture à lire.

**22.** Procédé suivant l'une des revendications 17 à 21, **caractérisé en ce que** l'on établit la direction d'aimantation de la ou des couches de référence magnétiques d'un élément ou des éléments de référence constitué(s) en cellules de mémoire qui est ou sont constitué(s) d'une succession de couches d'une couche de référence magnétique, d'une barrière tunnel et d'une couche de support d'informations d'une succession de couches de référence magnétiques de couches de découplage, de couches de support d'informations et de couches de découplage et d'une pluralité de cet agencement, tandis que la comparaison du signal (Vr) de référence au signal (Vs) de lecture s'effectue perpendiculairement à la direction ou aux directions d'aimantation de la couche ou des couches de support d'informations.

**Fig 2**

**Fig 1**

Fig 3

EP 1 003 176 B1

**Fig 4**

EP 1 003 176 B1

Fig 5

EP 1 003 176 B1

Fig 6

EP 1 003 176 B1

**Fig 7**

EP 1 003 176 B1

Fig 8

Fig 9

EP 1 003 176 B1

Fig 10

EP 1 003 176 B1

**Fig 11**

EP 1 003 176 B1

Fig 12